# EUROPEAN PATENT APPLICATION

(11) **EP 2 784 819 A2**
(43) Date of publication of application: **01.10.2014**
(21) Application number: 14158525.7
(22) Date of filing: 10.03.2014
(51) Int. Cl.: H01L 27/146

(54) **Infrared imaging device and infrared imaging module**

(30) Priority: 25.03.2013 JP 2013062762
(71) Applicant: Kabushiki Kaisha Toshiba, Tokyo 105-8001 (JP)
(72) Inventor: Ishii, Koichi, Tokyo 105-8001 (JP); Funaki, Hideyuki, Tokyo 105-8001 (JP); Fujiwara, Ikuo, Tokyo 105-8001 (JP); Honda, Hiroto, Tokyo 105-8001 (JP)
(74) Representative: HOFFMANN EITLE

(57) **Abstract**

An infrared imaging module (30) includes: an infrared imaging element (31) converting infrared rays to electrical signals; and a lid (33) including a lens portion (331) facing at least the part of the infrared imaging element, and a flat plate portion (332) surrounding the lens portion.

## Description

### FIELD

Embodiments described herein relate generally to infrared imaging devices and infrared imaging modules.

### BACKGROUND

Infrared imaging elements utilizing infrared rays are capable of taking images both in daytime and nighttime. Infrared rays pass through smoke and fog more easily than visible light rays, and can be used to obtain temperature information of a subject. For this reason, the infrared imaging elements can be applied to such fields as defense, surveillance cameras, and fire detection cameras.

An infrared imaging device using an infrared imaging element needs a light-collecting optical system for collecting infrared rays, which is one of the important components for determining the specification of the imaging element. In particular materials for transmitting far infrared rays are selected from Ge, Si, ZnSe, ZnS, etc.

Generally, a lens module serving as the aforementioned light-collecting optical system includes two or more lenses, which are aspherical lenses to secure required aberration and light amount distribution. The lenses are antireflection (AR) coated or diamond-like carbon (DLC) coated to have a sufficient transmission with respect to infrared rays. Crystalline materials such as Ge and Si have a high transmission, and are processed by polishing.

As described above, the optical system of the infrared imaging device is more expensive in the sense of materials and manufacturing process than that of visible light sensors. For this reason, the costs of infrared imaging devices are very expensive, which causes a restriction in market expansion.

### BRIEF DESCRIPTION OF THE DRAWINGS

Fig. 1 is a cross-sectional view showing an infrared imaging device according to the first embodiment.
Figs. 2(a) and 2(b) are a top view and a bottom view of a lid in the first embodiment.
Figs. 3(a) to 3(d) are cross-sectional views showing a process of manufacturing the lid in the first embodiment.
Figs. 4(a) to 4(d) are cross-sectional views showing the process of manufacturing the lid in the first embodiment.
Fig. 5 is a cross-sectional view showing an infrared imaging device according to a comparative example.
Fig. 6 is a cross-sectional view showing an infrared imaging device according to the second embodiment.
Figs. 7(a) and 7(b) are a top view and a bottom view of a lid in the second embodiment.
Figs. 8(a) and 8(b) are a plan view and a cross-sectional view of a pixel portion of the infrared imaging element according to the second embodiment.
Figs. 9(a) to 9(d) are cross-sectional views showing a method of bonding and sealing the lid and the infrared imaging element.
Figs. 10(a) and 10(b) are cross-sectional views showing the method of bonding and sealing the lid and the infrared imaging element.
Figs. 11(a) and 11(b) are cross-sectional views showing a process of forming through-vias in an infrared imaging element.
Figs. 12(a) to 12(c) are cross-sectional views showing manufacturing steps of forming through-vias in an infrared imaging element.
Figs. 13(a) and 13(b) are cross-sectional views for explaining a method of manufacturing infrared imaging modules using wafers.
Fig. 14 is a cross-sectional view showing an infrared imaging module according to the third embodiment.
Figs. 15(a) and 15(b) are a plan view and a cross-sectional view of a pixel portion of the infrared imaging element according to the third embodiment.
Fig. 16 is a schematic showing a coating pattern on a surface of the lid facing the infrared imaging element.
Fig. 17 is a schematic showing another example of coating pattern on the surface of the lid facing the infrared imaging element.
Fig. 18 is a cross-sectional view of an infrared imaging module according to the fourth embodiment.
Figs. 19(a) to 19(c) are cross-sectional views showing part of a process of manufacturing the infrared imaging module according to the fourth embodiment.
Fig. 20 is a top view showing another example of the lid in the first embodiment.

### DETAILED DESCRIPTION

An infrared imaging module according to an embodiment includes: an infrared imaging element converting infrared rays to electrical signals; and a lid including a lens portion facing at least the part of the infrared imaging element, and a flat plate portion surrounding the lens portion.

Embodiments will now be explained with reference to the accompanying drawings.

### (First Embodiment)

An infrared imaging device according to the first embodiment includes an infrared imaging element for converting infrared rays to electrical signals, a package, a lid, and a lens module. The package has a recessed portion to which the infrared imaging element is fixed and a periphery portion surrounding the recessed portion. The lid has a lens portion facing the infrared imaging element and a flat plate portion surrounding the lens portion and bonded to the periphery portion of the package. The lens module has a lens facing the lens portion of the lid. The package and the lid can be bonded to each other by means of a multilayer structure including a first metal layer, a plating layer, and a second metal layer. The lid may have a first antireflection film on a surface facing the lens. The lid may have a second antireflection film on a surface of the lens portion facing the infrared imaging element. The lid may have a getter on a surface of the flat plate portion facing the infrared imaging element. The lid may have the first antireflection film on a surface of the lens portion facing the lens. The lid may have an infrared ray absorption film on a surface of the flat plate portion facing the lens. The lid may have an antireflection film on the surface of the lens portion facing the infrared imaging element.

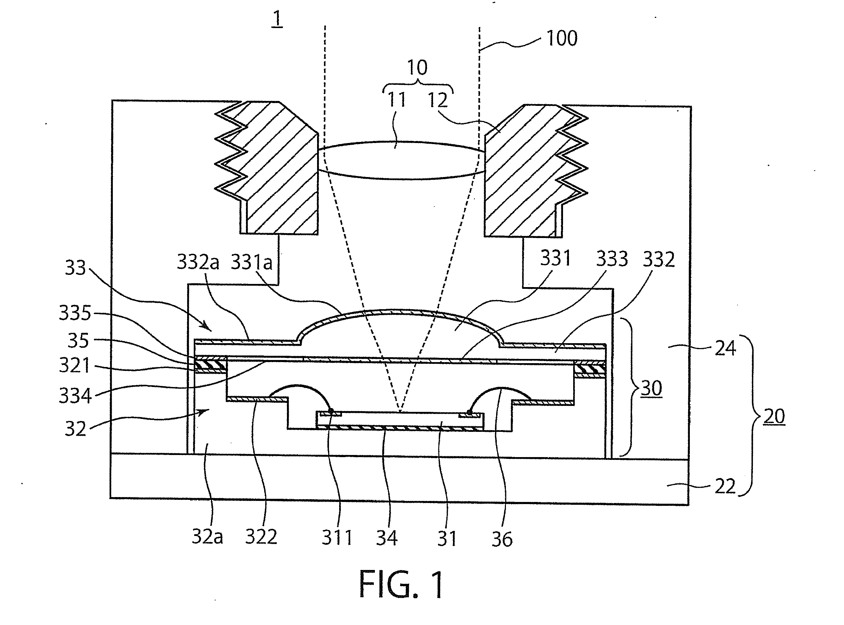

Fig. 1 shows a cross-section of the infrared imaging device according to the first embodiment. The infrared imaging device 1 according to the first embodiment includes a lens module 10, a lens fixing unit 20, and an infrared ray sensor module 30. The lens module 10 includes a lens 11 and a lens fitting unit 12 to which the lens 11 is fitted. The lens 11 is basically formed of an infrared ray transmitting material such as germanium, silicon, zinc sulfide, and chalcogenide grass. An antireflection film is preferably formed on a surface of the lens 11. The lens module 10 is fixed to the lens fixing unit 20 via the lens fitting unit 12 so that an imaging plane of the lens 11 is positioned on the top surface of an infrared imaging element, which will be described later.

The lens fixing unit 20 includes a board 22 on which the infrared ray sensor module 30 is mounted, and a fixing unit 24 on the board 22 for fixing the lens fitting unit 12. The position of the imaging plane of the lens 11 is adjusted by a screw on an outer portion of the lens fitting unit 12 and a screw on an inter portion of the fixing unit 24.

The infrared ray sensor module 30 includes an infrared imaging element 31, a package 32, and a lid 33. The infrared imaging element 31 is fixed to the package 32 with a die-mount material 34 such as AuSn. The infrared imaging element 31 has an electrode pad 311 on a surface and connected to a pad 322 for electrical connection on the package side with a bonding wire 36. The lid 33 is used as a hermetically sealing cover of the infrared imaging element. The lid of the first embodiment further has a lens function, and includes a lens portion 331 and a flat plate portion 332. The lens portion 331 is provided on the side opposing the lens 11. The base material of the lid 33 is preferably an infrared ray transmitting material such as germanium and silicon. A coating layer 331a is formed on the lens portion 331 and a coating layer 332a is formed on the flat plate portion 332 on the surface of the lid 33 facing the lens 11. The coating layer 331a and the coating layer 332a in the first embodiment are antireflection films. A metal layer 335, a getter 334, and an antireflection film 333 are formed on a surface of the lid 33 facing the infrared imaging element 31.

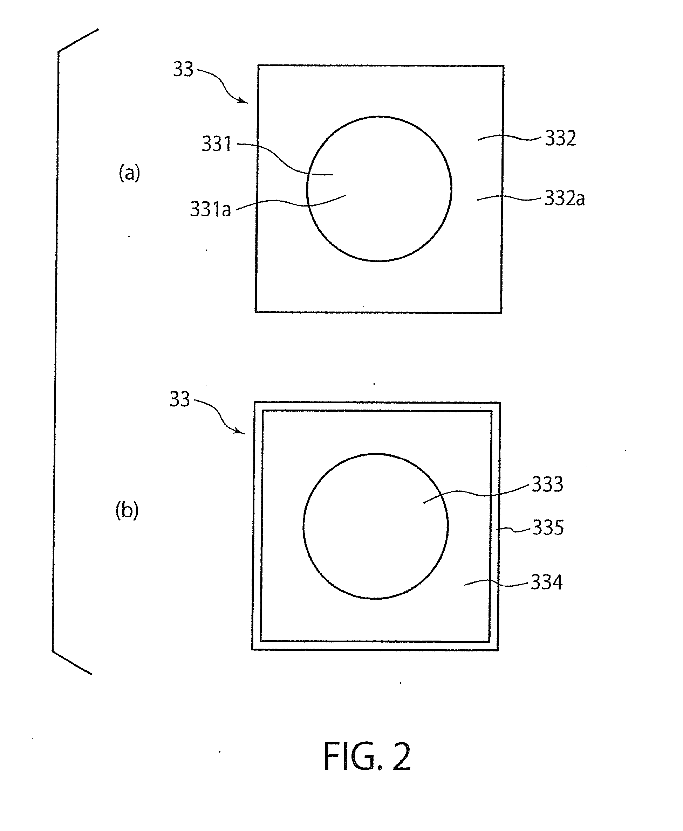

Figs. 2(a) and 2(b) show a top view and a bottom view of the lid 33 respectively. Fig. 2(a) is a plan view of the surface of the lid 33 facing the lens 11, and Fig. 2(b) is a plan view of the lid 33 facing the infrared imaging element 31. As described above, the antireflection films 331a, 332a are formed on the lens portion 331 and the flat plate portion 332 of the surface facing the lens 11 shown in Fig. 2(a). The metal layer 335 is formed on the periphery portion of the lid 33, and the antireflection film 333 is formed on a portion corresponding to the lens portion 331 shown in Fig. 2(b). The getter 334 is formed on the other portion.

The package 32 includes a main body 32a, a pad electrode 322 for electrically connected to the infrared imaging element 31, and an electrode frame 321 for fixing the lid 33. The main body 32a has a first recessed portion on the center thereof, a second recessed portion surrounding the first recessed portion and being shallower than the first recessed portion, and a support portion surrounding the second recessed portion to support the lid 33. The distance between the base of the first recessed portion and the surface of the lid 33 facing the infrared imaging element is longer than the distance between the vase of the second recessed portion and the surface of the lid 33 facing the infrared imaging element 31. The distance between the base of the second recessed portion and the surface of the lid 33 facing the infrared imaging element is longer than the distance between the top of the support portion and the surface of the lid 33 facing the infrared imaging element 31. The infrared imaging element 31 is mounted via the die-mount material 34 on the first recessed portion, the pad electrode 322 is formed on the second recessed portion, and the electrode frame 321 is formed on the support portion. The electrode frame 321 of the package 32 and the metal layer 335 of the lid 33 are bonded by the sealing member 35. The base material. of the main body 32a is preferably a ceramic material such as alumina and aluminum nitride. A metal material such as gold, aluminum, and copper can be used to form the pad electrode 322 and the electrode frame 321.

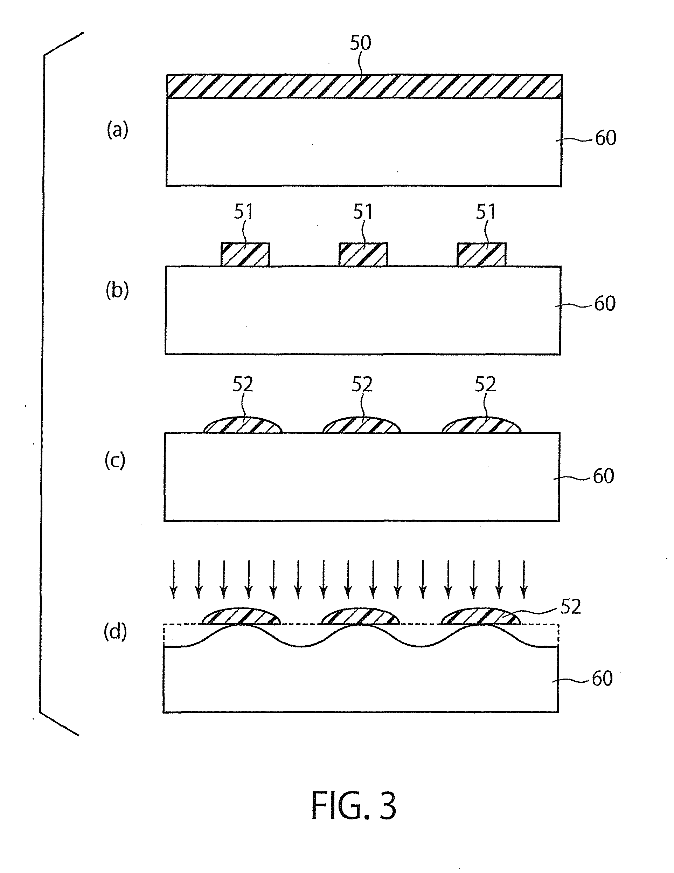

Next, a method of manufacturing the lid 33 having a lens function according to the first embodiment will be described with reference to Figs. 3(a) to 4(d).

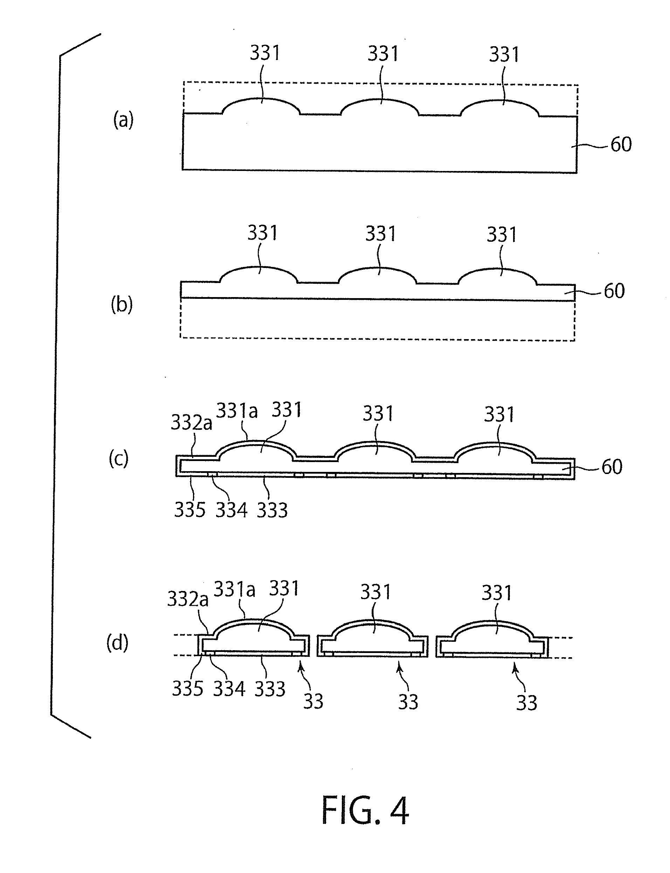

First, a resist 50 is uniformly applied to a silicon substrate 60, which is a base member of the lens (Fig. 3(a)). Subsequently, the resist 50 is exposed to light and developed using a mask that is not shown, to form resist patterns 51 that are separated from each other (Fig. 3(b)). The resist patterns 51 are heated to become resist patterns 52 each having a lens shape (Fig. 3(c)). Ion beams are emitted from above the resist patterns 52 to perform etching (Fig. 3(d)). As a result, lens portions 331 each having the same shape as the lens shape of each resist pattern 52 are formed on the surface of the silicon substrate 60 (Fig. 4(a)).

Next, the surface of the silicon substrate 60 on which the lens portions 331 are formed and a surface of the silicon substrate 60 opposite to the lens portions 331 are polished to have a desired thickness and to have a smooth surface (Fig. 4(b)). Thereafter, both the surfaces of the silicon substrate 60 having the lens portions 331 are coated. Specifically, the antireflection films 331a, 332a are formed on the surface of the lens portion 331 and the surface of the flat portion, and the antireflection film 333, the getter 334, and the metal layer 335 are formed on the surface opposite to the surface having the lens portion 331 according to the patterns shown in Figs. 2(a) and 2(b) (Fig. 4(c)). Finally, the lids 33 are separated by dicing to have individual lids 33 (Fig. 4(d)).

The lid 33 is fixed to the package 32 by the sealing member 35 under vacuum atmosphere. The inside of the package 32 is sealed in a vacuum sate at a pressure of 1 Pa or less. A soldering material such as AuSn can be used to form the sealing member 35. The sealing is performed by bonding the metal layer 335 on the lid 33 side and the metal frame 321 on the package 32 side (Fig. 1).

Next, the light collecting path of the incident infrared rays of the first embodiment will be described. As shown in Fig. 1, incident infrared rays 100 to the infrared imaging device 1 from outside are collected by the lens 11 and focused on the infrared imaging element 31 by the lens portion 331 of the lid 33.

### (Comparative Example)

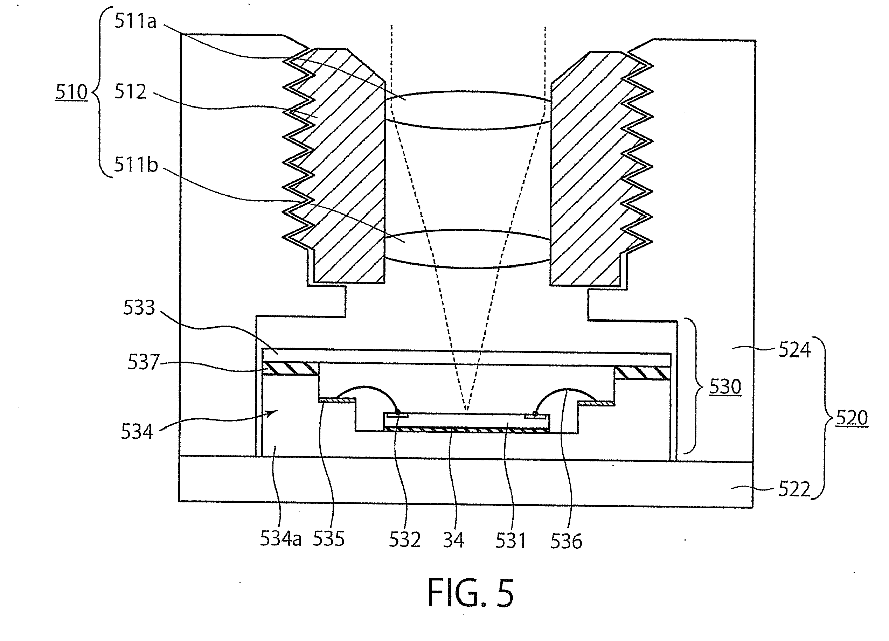

Fig. 5 is a cross-sectional view of an infrared imaging device according to a comparative example. The infrared imaging device according to the comparative example includes a lens module 510, a lens fixing unit 520, and an infrared ray sensor module 530. The lens module 510 has two lenses 511a, 511b and a lens fitting unit 512 to fit the lenses 511a, 511b.

The lens fixing unit 520 has a board 522 on which the infrared ray sensor module 530 is mounted, and a fixing unit 524 formed on the board 522 to fix the lens fitting unit 512.

The infrared ray sensor module 530 has an infrared imaging element 531, a package 534, and a lid 533. The infrared imaging element 531 is fixed to the package 534 with a die-mount material 34 such as AuSn. The infrared imaging element 531 has an electrode pad 532 on the infrared ray incident surface, which is connected to a pad 535 for electrical connection by means of a bonding wire 536.

The package 534 has a pad electrode 535 for electrically connecting a main body 534a to the infrared imaging element 531. The main body 534a has a first recessed portion in the center thereof, a second recessed portion surrounding the first recessed portion and being shallower than the first recessed portion, and a support portion surrounding the second recessed portion and supporting the lid 533. The infrared imaging element 531 is mounted on the first recessed portion via the die-mount material 534, and the pad electrode 535 is formed in the second recessed portion. The support portion of the package 534 and the lid 533 are bonded and sealed by a sealing member 537.

As shown in Fig. 5, the lens module 510 of the optical system of the infrared imaging device according to the comparative example includes two lenses (first lens 511a, second lens 511b). Furthermore, the lid 533 of the infrared ray sensor module 530 has a flat plate structure. With such a structure of the comparative example, infrared rays from outside pass the two lenses 511a, 511b of the lens module 510 and the lid 533 to focus on the infrared imaging element 531 in the infrared ray sensor module 530. In this case, the number of elements constituting the optical system is three.

On the other hand, in the first embodiment, the lid 33 of the infrared ray sensor module 30 also serves as a lens. Accordingly, the number of elements constituting the optical system is two. Thus, the number of lenses used in the lens module can be reduced by one as compared to the comparative example. Accordingly, the costs can be reduced with the performance of both the lens module and the infrared imaging device being maintained. Furthermore, as the number of the optical elements transmitting the infrared rays from outside is decreased, the infrared energy arriving at the infrared ray imaging element 531 is increased. As a result, the sensitivity of the infrared imaging device can be increased.

### (Another Example of Lid)

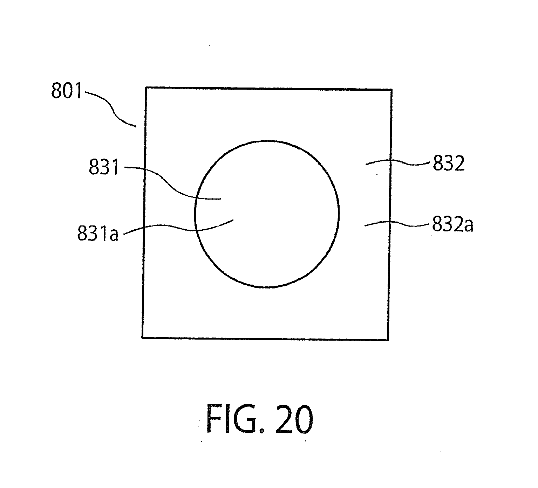

Fig. 20 shows another example of the lid of the infrared imaging device according to the first embodiment.

Fig. 20 shows a surface of a lid 801 facing the lens, as in the case of Fig. 2(a). Although the antireflection film is formed on the entire surface of the lid shown in Fig. 2(a), an antireflection film 831a is formed on a lens portion 831 of the lid 801 shown in Fig. 20, and an infrared ray absorption film 832a is formed on a flat plate portion 832 that correspond to the remaining portion. The infrared ray absorption film 832a is preferably formed of a material with high infrared ray absorption efficiency such as carbon. If the antireflection film is formed on the entire surface of the lid, and if stray light rays, which are part of incident infrared rays from the lens 11 reflected on the surface of the lens portion of the lid, are incident to the lid again, the possibility that the stray light rays
may pass through the lid is high. The stray light rays incident to the infrared imaging element make a ghost image, which adversely affects images. In contrast, the infrared ray absorption film 832a formed on the lid as shown in Fig. 20 absorbs the stray light rays that are to be incident again, and prevents the stray light rays from being incident to the infrared imaging element. Stray light rays to be incident to the lens portion 831 again cannot be prevented from being incident to the infrared imaging element. However, the infrared ray absorption film 832a formed on the lid 801 can considerably reduce the possibility that the stray light rays are incident to the lens portion 831 again. In this manner, images can be obtained more stably.

### (Second Embodiment)

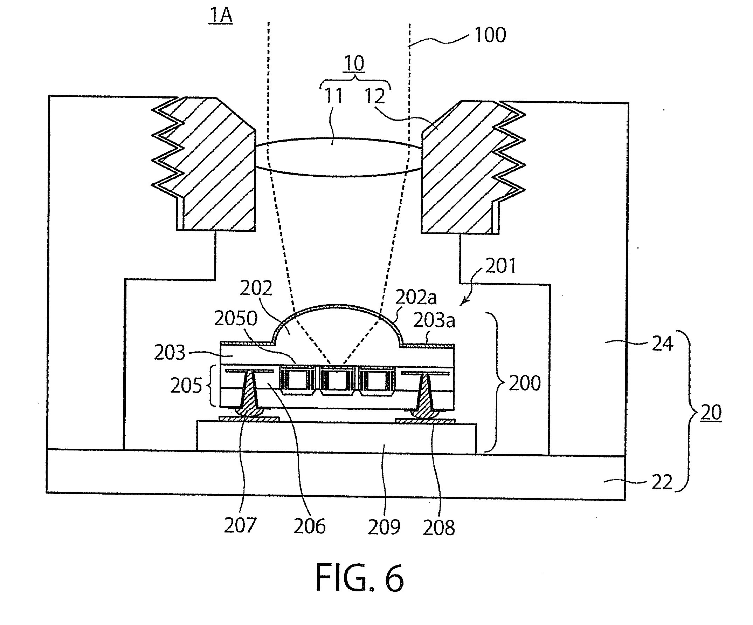

Fig. 6 shows a cross section of an infrared imaging device according to the second embodiment. The infrared imaging device 1A according to the second embodiment includes an infrared imaging element and a lid. The infrared imaging element has a semiconductor substrate with recessed portions, and a pixel portion formed on the recessed portions and converts infrared rays to electrical signals. The lid has a lens portion facing the pixel portion, and a flat plate portion surrounding the lens portion and bonded to the semiconductor substrate. The infrared imaging device 1A may further have a lens module with a lens facing the lens portion of the lid. The lid may have antireflection films on a first surface facing the infrared imaging element and a second surface on the opposite side of the first surface.

The lid has a first region facing the infrared imaging element and a second region occupying the region other than the first region on the first surface facing the infrared imaging element. The second region may have a getter. The semiconductor substrate and the lid may have substantially the same size, or the lid may be smaller than the semiconductor substrate.

Specifically, the infrared imaging device 1A according to the second embodiment includes a lens module 10, a lens fixing unit 20, an infrared ray sensor module 200, and a circuit board 209. The circuit board 209 receives output signals from the infrared ray sensor module 200. The lens module 10 and the lens fixing unit 20 have the same structures as those in the first embodiment. Accordingly, these elements are not described in detail.

The infrared ray sensor module 200 has a lid 201 having a lens function and an infrared imaging element 205. The structure of the lid 201 is basically the same as that of the lid 33 of the first embodiment. However, although the lid 33 has substantially the same size as the package 32, the lid 201 has substantially the same size as the infrared imaging element 205. Furthermore, the coating patterns formed on the lid 201 are different from those in the first embodiment.

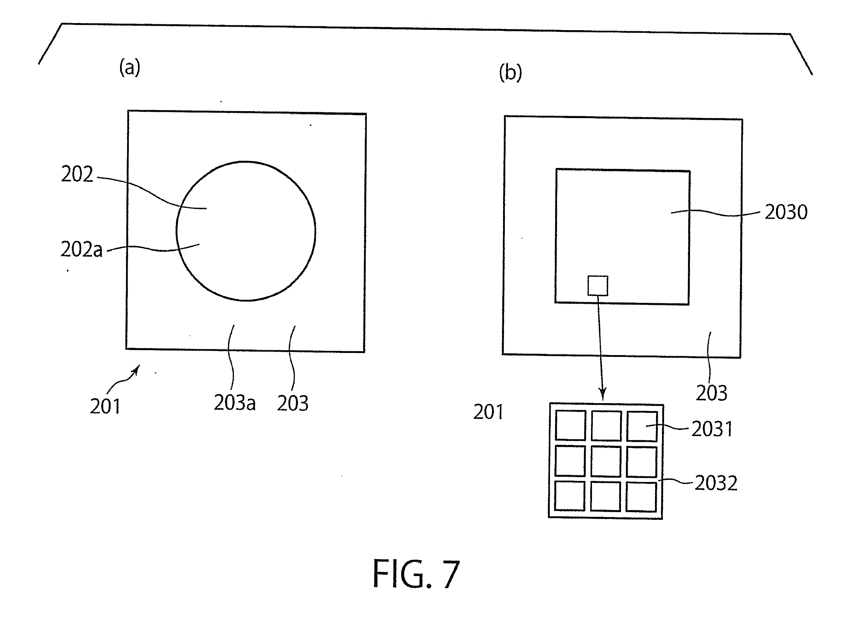

Figs. 7(a) and 7(b) are a top view and a bottom view of the lid 201. As shown in Fig. 7(a), antireflection films 202a, 203a are formed on both a lens portion 202 and a flat plate portion 203 of a surface of the lid 201 facing the lens 11. On the opposite side of the lid 201, an antireflection film pattern is formed on a rectangular region 2030 corresponding to the lens portion 202, as shown in Fig. 7(b). Antireflection films formed on fine rectangular regions 2031 in the rectangular region 2030 correspond to pixels of the infrared ray imaging element 205, which will be described later, and silicon that is the base material of the lid 201 is exposed in the region 2032 filling the spaces between the fine rectangular regions 2031.

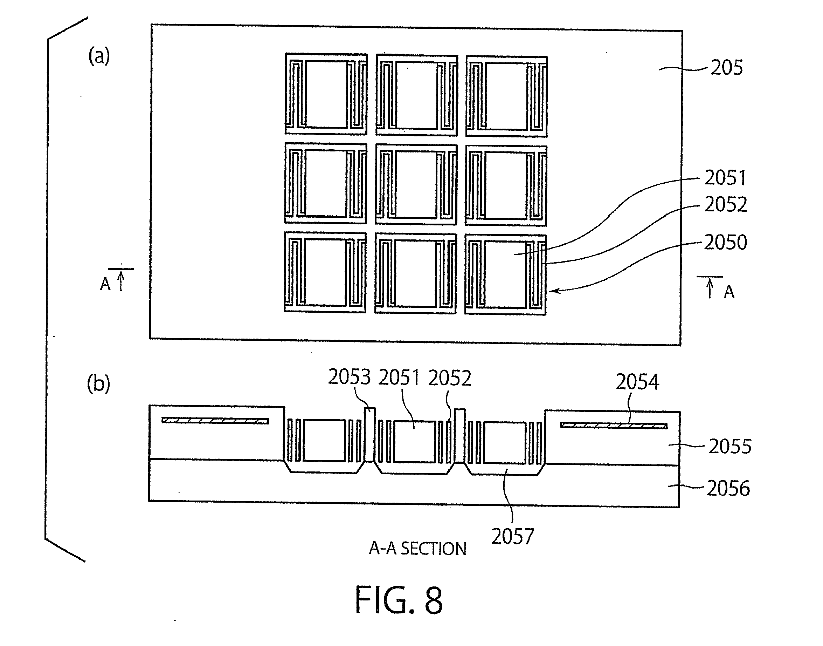

Fig. 8(a) is a plan view of the pixel portion of the infrared imaging element 205, and Fig. 8(b) is a cross-sectional view taken along line A-A in Fig. 8(a). The infrared imaging element 205 has a plurality of pixels 2050 arranged in a matrix form to constitute a two-dimensional array (Fig. 8(a)). The pixels 2050, which receive infrared rays emitted from outside, are formed on a pixel forming layer 2055 on a silicon substrate 2056. Each pixel 2050 has a sensor cell 2051 for absorbing incident infrared rays and supporting legs 2052 for supporting the sensor cell 2051. There is a cavity region 2057 below the sensor cell 2051 and the supporting legs 2052 (Fig. 8(b)).

A wiring region 2053 extends between the pixels 2050, and the wiring region 2053 includes wiring lines for exchanging electrical signals between the pixels and a pixel driving circuit not shown in Figs 8(a) and 8(b). The infrared ray imaging element 205 further includes a pad layer 2054 for exchanging electrical signals between the infrared ray imaging element 205 and the circuit board. As shown in Fig. 6, the pad layer 2054 and the circuit board electrode 208 on the circuit board are electrically connected with each other by through-vias 207 formed in the infrared imaging element 205.

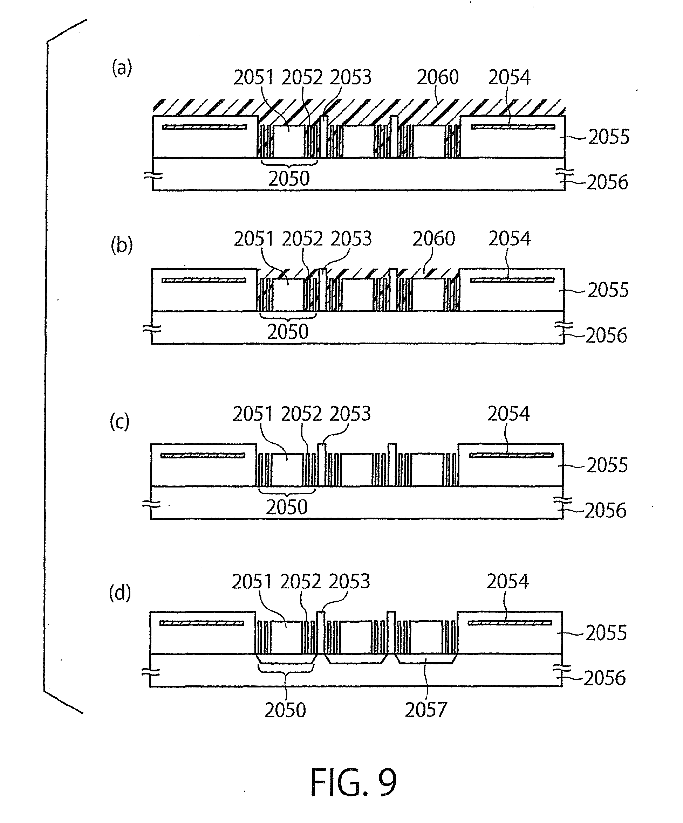

The lid 201 and the infrared imaging element 205 are bonded and sealed under vacuum atmosphere. Figs. 9(a) to 10(b) show the bonding method. The requirement in the bonding is that the surface of the infrared imaging element 205 has a predetermined level of roughness. Accordingly, first a resist 2060 is applied to a surface of a chip or wafer on which the infrared imaging element is, or elements are formed (Fig. 9(a)). The resist 2060 is also filled into spaces between the sensor cells 2051 and the supporting legs 2052. Therefore, the polishing in the next step does not break the structures of the sensor cells 2051 and the supporting legs 2052. In this stage, no cavity region 2057 is formed in the infrared imaging element 205.

Next, the surface on which the resist 2060 is formed of the chip or wafer described above is polished to obtain the predetermined roughness (Fig. 9(b)). The surface roughness Ra at this time is, for example, 1 nm or less. After the resist 2060 is removed (Fig. 9(c)), the cavity regions 2057 are formed below the sensor cells 2051 and the supporting legs 2052 of the infrared imaging element 205 (Fig. 9(d)). The cavity regions 2057 can be formed by anisotropy wet etching.

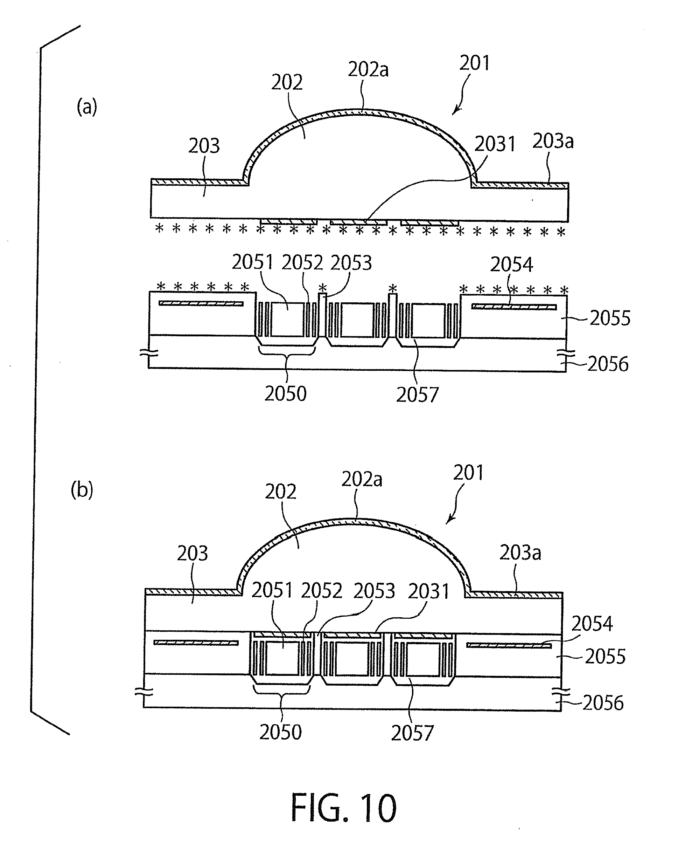

Next, the bonding surface is polished to have the predetermined roughness, and the bonding surface of the lid 201, on part of which the antireflection films 2031 are formed, and the bonding surface of the infrared imaging element 205 are plasma activated (Fig. 10(a)). The bonding surface of the lid 201 is formed of silicon, and the bonding surface of the infrared imaging element 205 is formed of SiO₂ or SiN. Finally, the bonding surfaces are caused to be in contact with each other in vacuum atmosphere, by which the silicon of the lid 201 and SiO₂ or SiN of the infrared imaging element 205 are coupled with each other in the atom level, thereby bonding and sealing the lid 201 and the infrared imaging element 205 (Fig. 10(b)). As a result, the vacuum state in the space in each pixel 2050 of the infrared imaging element 205 is maintained.

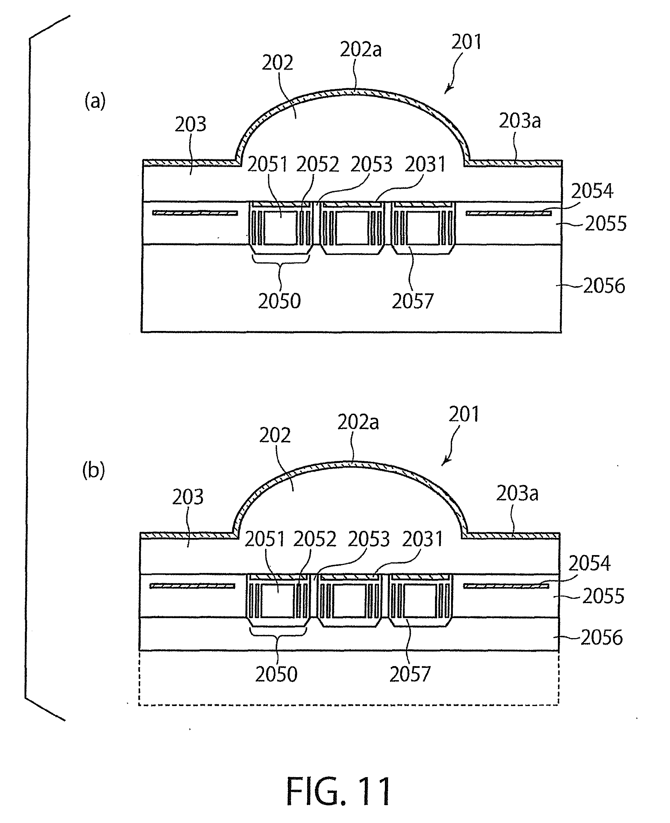

Figs. 11(a) to 12(c) show a process of forming the through-vias 207 in the infrared imaging element 205. Fig. 11(a) shows the state after the lid 201 and the infrared imaging element 205 are bonded to each other. The thickness of the infrared imaging element 205 is substantially the same as that of the silicon substrate 2056 in the original state. The thickness can be decreased by polishing the infrared imaging element 205 from the back side (Fig. 11(b)). For example, the thickness of the silicon substrate 2056 can be decreased from 625 µm to 100 µm.

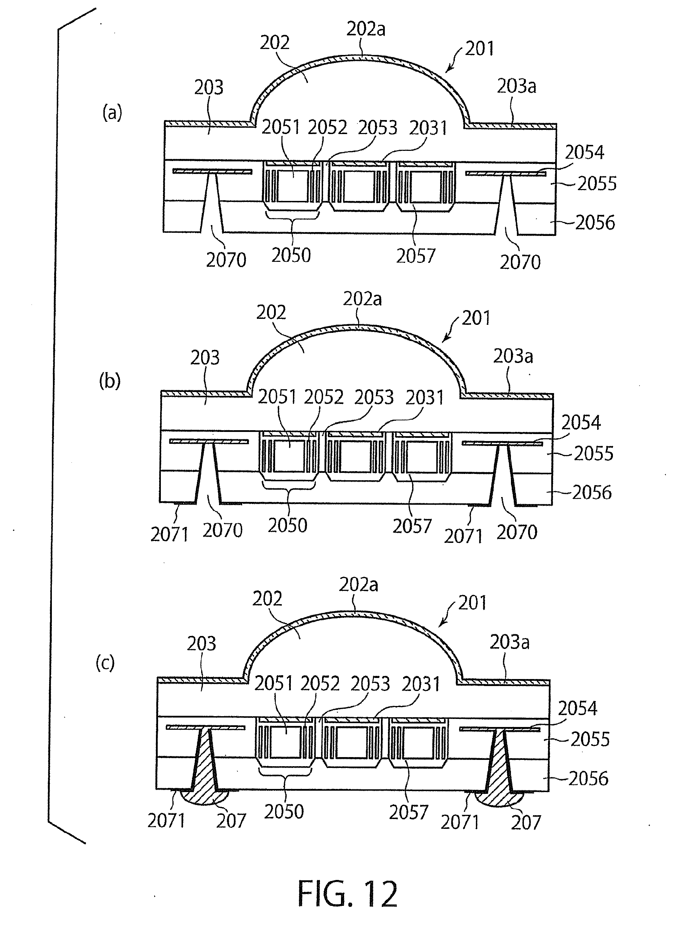

Next, patterning and etching of the backside of the infrared imaging element 205 using a resist is performed until holes 2070 reaching the pad layer 2054 are obtained by the etching (Fig. 12(a)). An insulating film 2071 covering the inner wall of each hole 2070 and a portion surrounding the opening of each hole 2070 is formed (Fig. 12(b)). Subsequently, a metal is filled into the holes 2070, thereby forming the through-vias 207 (Fig. 12(c)). The metal to be filled into the holes 2070 is preferably copper. The metal can be filled by plating.

The operation of the infrared imaging device according to the second embodiment is the same as that of the infrared imaging device according to the first embodiment shown in Fig. 1. For example, infrared rays 100 emitted from outside pass through the lens 11 and the lid 202, and focus on the pixels 2050 of the infrared imaging element 205 to form an image (Fig. 6).

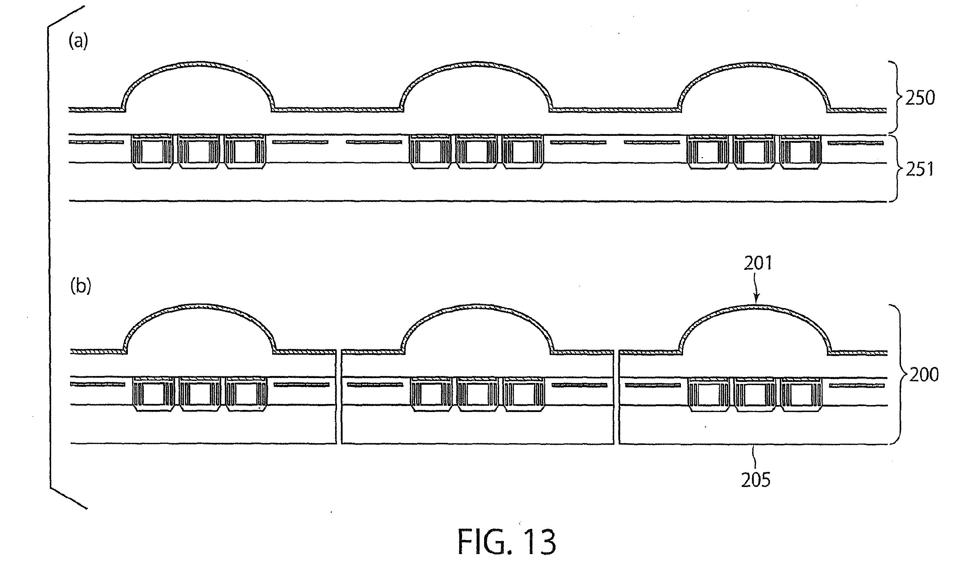

The number of elements constituting the optical system of the second embodiment is two, the lens of the lens module and the lens portion of the lid. Thus, the same effect as that of the first embodiment can be obtained. In addition, since the infrared ray sensor module does not need a package, a further reduction in costs can be achieved. Although the infrared imaging module 200 of the second embodiment is described to be manufactured unit by unit (chip by chip), the manufacturing method is not limited to this method, and the infrared imaging modules can be manufactured in the unit of wafer. For example, Fig. 13(a) is a cross-sectional view showing that a lid wafer 250, on which lens portions are formed, and a device wafer 251, on which infrared imaging elements are formed, are bonded with each other. The bonding method is the same as that in the case described with reference to Fig. 10(a). Thereafter, individual infrared imaging modules are separated by dicing (Fig. 13(b)). The through-vias 207 described with reference to Fig. 12(a) can also be formed when the infrared imaging modules are still on the wafer, and then the infrared imaging modules can be separated by dicing.

### (Third Embodiment)

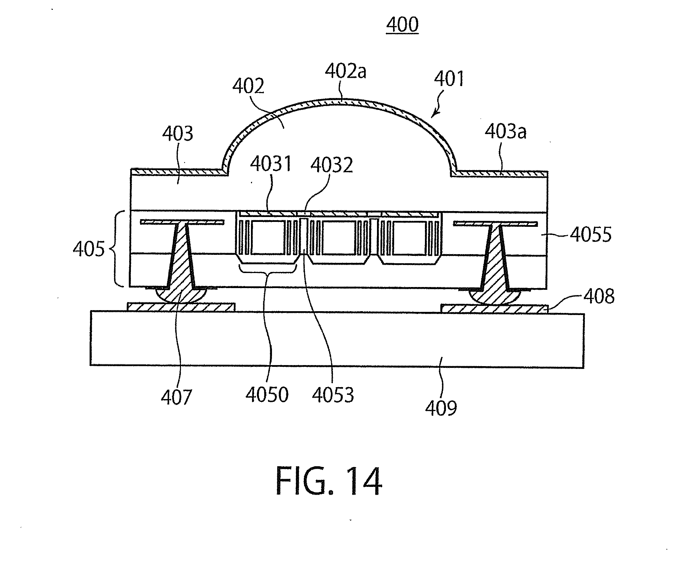

Fig. 14 shows a cross section of an infrared imaging module according to the third embodiment. The infrared imaging module 400 according to the third embodiment has the same structure as the infrared imaging module 200 according to the second embodiment shown in Fig. 6 except for the coating pattern on the surface of a lid 401 facing an infrared imaging element 405, and the pixel structure of the infrared imaging element 405.

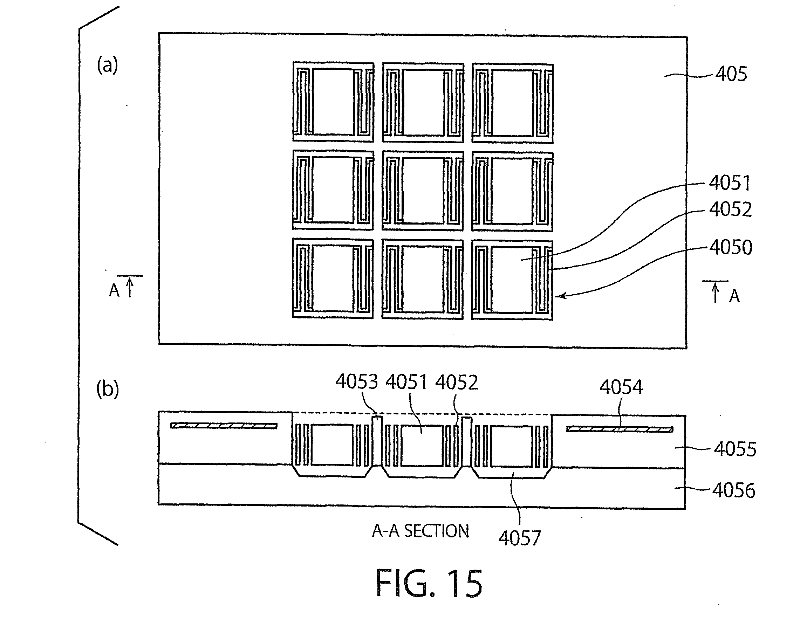

Fig. 15(a) is a plan view of the infrared imaging element 405 according to the third embodiment, and Fig. 15(b) is a cross-sectional view taken along line A-A in Fig. 15(a). In the third embodiment, the height of a wiring region 4053 is lower than that of a pixel forming layer 4055 at which the infrared imaging element 405 is bonded to the lid 401. This is the difference between the third embodiment and the second embodiment shown in Figs. 8(a) and 8(b), in which the wiring region 2053 is at the same height as the pixel forming layer 2055.

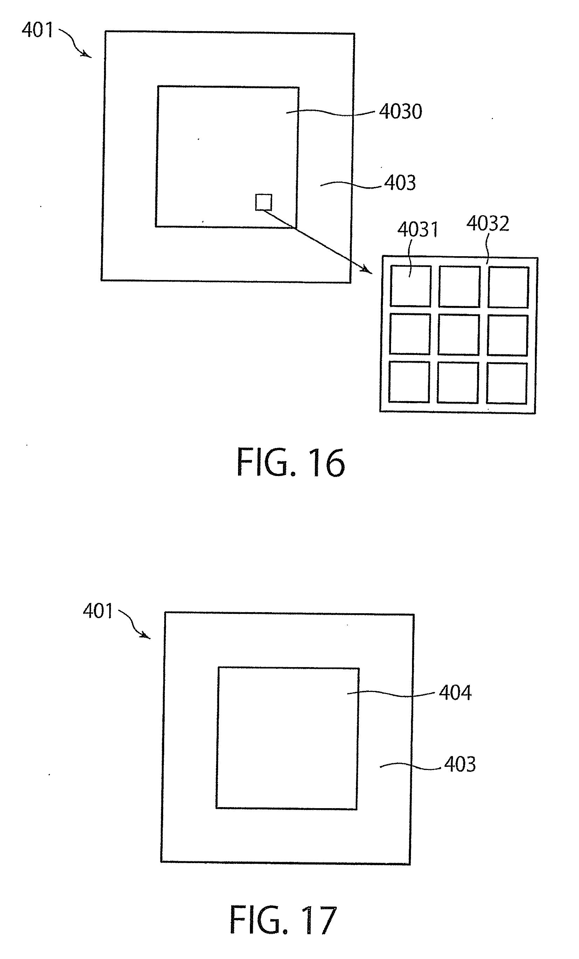

Fig. 16 shows a coating pattern on a surface of the lid 401 facing the infrared imaging element 405. Fine rectangular regions 4031 corresponding to pixels 4050 are formed in a rectangular region 4030 corresponding to the lens portion 402 of the lid 401. The fine rectangular regions 4031 are formed of antireflection films. A getter 4032 is formed in a region where the fine rectangular regions 4031 are not present in the rectangular region 4030. As shown in Fig. 14, the fine rectangular regions 4031 face the pixels 4050, and the getter 4032 faces the wiring region 4053. Since the wiring region 4053 is lower than the pixel forming layer 4055, the getter 4032 is not allowed to be in contact with the wiring region 4053. Accordingly, the getter 4032 positioned to face the wiring region 4053 does not adversely affect the bonding of the lid 401 and the infrared imaging element 405. The getter 4032 on the surface of the lid 401 in the third embodiment is capable of absorbing outgas produced in a space between the lid 401 and the infrared ray imaging element 405, by which the degree of vacuum in the space can be maintained at a constant level.

Fig. 17 shows another example of coating pattern on the surface of a lid 401 facing the infrared imaging element 405. In the example shown in Fig. 17, an antireflection film covers the entire rectangular region 404 corresponding to the lens portion 402. Since the wiring region 4053 is lower than the pixel forming layer 4055, the rectangular region 4031 formed of an antireflection film is not allowed to be in contact with the wiring region 4053. Accordingly, the antireflection film positioned to face the wiring region 4053 does not adversely affect the bonding of the lid 401 and the infrared imaging element 405. Such a constant pattern of the antireflection film helps to eliminate fine alignment of the lid 401 and the infrared ray imaging element 405. Accordingly, the assembling of the infrared ray imaging module becomes easier.

### (Fourth Embodiment)

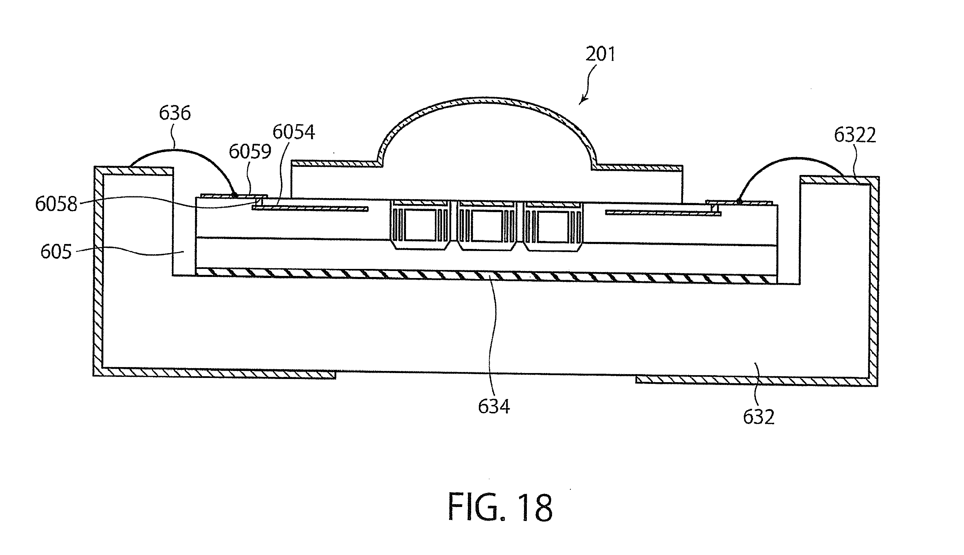

Fig. 18 shows a cross section of an infrared imaging module according to the fourth embodiment. In the fourth embodiment, the size of the lid 201 having a lens structure is smaller than that of the infrared imaging element 605, and bonded to the infrared imaging element 605 substantially at the center of the infrared imaging element 605. The infrared imaging element 605 includes a pad electrode 6059 at a position outside the position to which the lid 201 is bonded. The pad electrode 6059 is connected to an internal conductive layer 6054 of the infrared imaging element 605 by means of vias 6058. The infrared imaging element 605 is fixed to the package 632 by means of a die attach material 634.

The package 632 includes a pad 6322, the wire of which extends to the backside of the package. The pad electrode 6059 of the infrared imaging element 605 and the pad 6322 are electrically connected to each other by means of wire 636.

In the fourth embodiment, electrical signals from the infrared imaging element 605 are transferred to an external circuit board via the package 632. The infrared imaging element 605 is sealed by the lid 201. Thus, the structure of the package 632 is simple. Furthermore, no through-via is used to obtain electrical signals from the infrared imaging element 605. Accordingly, part of the manufacturing process can be simplified. As a result, the manufacturing costs and the material costs of the infrared imaging device can be reduced. The operation of the infrared imaging device according to the fourth embodiment is expected to be the same as that of the second embodiment shown in Fig. 6.

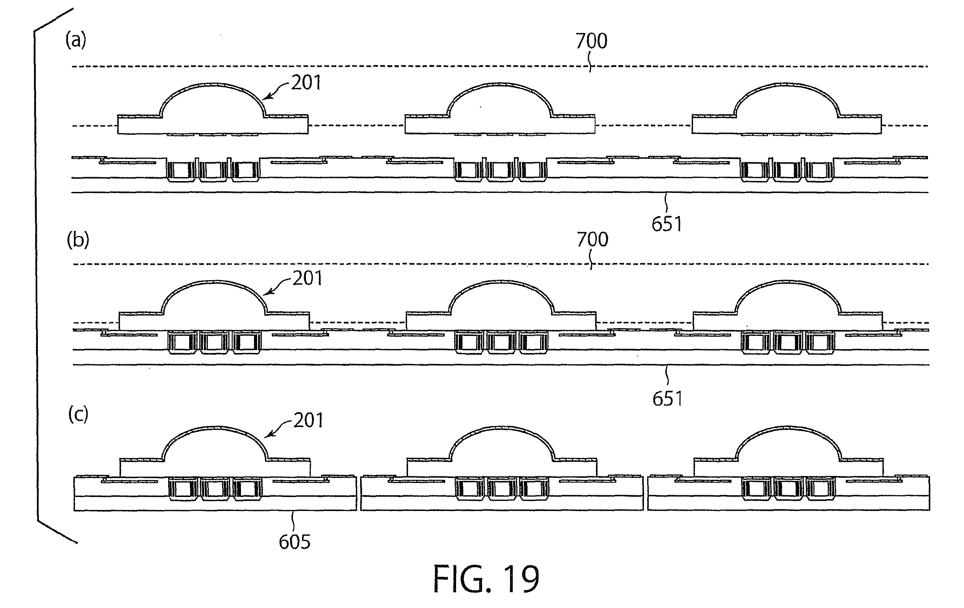

Figs. 19(a) to 19(c) show part of a process of manufacturing an infrared imaging module according to the fourth embodiment. Since the size of the lid 201 differs from that of the infrared imaging element 605 in the fourth embodiment, they cannot be bonded together if they are on wafers. Accordingly, a fixing member 700 for holding individual lids 201 are prepared, and a device wafer 651 including infrared imaging elements are prepared (Fig. 19(a)).

Then, as in the same as the process described with reference to Figs. 9(a) to Fig. 10(b), the surfaces of the fixing member 700 and the device wafer are polished, and bonded together by causing them to be in contact with each other under vacuum atmosphere (Fig. 19(b)). Thereafter, individual infrared imaging modules are separated by dicing. By assembling the modules using a wafer on which infrared imaging elements are formed, the manufacturing can be performed efficiently.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. An infrared imaging module comprising:
an infrared imaging element converting infrared rays to electrical signals; and
a lid including a lens portion facing at least the part of the infrared imaging element, and a flat plate portion surrounding the lens portion.

2. An infrared imaging module according to claim 1, wherein the infrared imaging element includes a semiconductor substrate having a recessed portion, and a pixel portion formed on the recessed portion, the pixel portion converting infrared rays to electrical signals, the lens portion faces the pixel portion, and the flat plate portion is bonded to the semiconductor substrate.

3. The module according to claim 2, wherein the lid includes antireflection films provided with the first surface facing the infrared imaging element and a second surface that is opposite to the first surface.

4. The module according to claim 2 or 3, wherein the lid includes a first region facing the infrared imaging element and a second region that is a remaining region on a first surface facing the infrared imaging element, the second region having a getter.

5. The module according to claim 2, 3 or 4, wherein a planar shape of the semiconductor substrate and a planar shape of the lid have substantially the same size.

6. The module according to claim 2, 3 or 4, wherein a planar shape of the lid is smaller than a planar shape of the semiconductor substrate.

7. An infrared imaging device comprising:
the infrared imaging module according to any one of the preceding claims further comprising;
a package including a recessed portion in which the infrared imaging element is fixed, and a periphery portion surrounding the recessed portion; and
a lens module including a lens facing the lens portion of the lid, wherein the flat plate portion of the lid is bonded to the periphery portion of the package.

8. The device according to claim 7, wherein the package and the lid are bonded to each other by means of a multilayer structure including a first metal layer, a solder layer, and a second metal layer.

9. The device according to claim 7 or 8, wherein the lid includes a first antireflection film formed on a surface facing the lens, a second antireflection film formed on a surface of the lens portion facing the infrared imaging element, and a getter formed on a surface of the flat plate portion facing the infrared imaging element.

10. The device according to claim 7 or 8, wherein the lid includes a first antireflection film formed on a surface of the lens portion facing the lens, an infrared ray absorption film formed on a surface of the flat plate portion facing the lens, a second antireflection film formed on a surface of the lens portion facing the infrared imaging element, and a getter formed on a surface of the flat plate portion facing the infrared imaging element.
